# EUROPEAN PATENT SPECIFICATION

(11) **EP 4 576 186 B1**
(45) Date of publication and mention of the grant of the patent: **22.07.2026**
(21) Application number: 24219577.4
(22) Date of filing: 12.12.2024
(51) Int. Cl.: H10D 1/60, H10W 20/00, H10W 20/20, H10W 20/40, H10W 20/41

(54) **SEMICONDUCTOR CIRCUIT WITH BACKSIDE DECOUPLING CAPACITORS AND METHOD OF FABRICATION**
HALBLEITERSCHALTUNG MIT RÜCKSEITIGEN ENTKOPPLUNGSKONDENSATOREN UND ZUGEHÖRIGE HERSTELLUNGSMETHODE
CIRCUIT SEMI-CONDUCTEUR AVEC DES CONDENSATEURS DE DÉCOUPLAGE ET PROCÉDÉ DE FABRICATION CORRESPONDANT

(30) Priority: 21.12.2023 IN 202341087862
(43) Date of publication of application: 25.06.2025
(73) Proprietor: NXP B.V., 5656 AG Eindhoven (NL)
(72) Inventor: Reber, Douglas Michael, 5656AG Eindhoven (NL); Bhooshan, Rishi, 5656AG Eindhoven (NL)
(74) Representative: Schwarzweller, Thomas

(56) References cited:
- US-A1- 2002 020 862
- US-A1- 2022 293 513
- US-B2- 11 502 031

## Description

### BACKGROUND OF THE INVENTION

### Field of the Invention

The present disclosure is directed in general to the field of semiconductor devices. In one aspect, the present disclosure relates to power and ground connector structures formed on and through semiconductor devices.

### Description of the Related Art

Conventionally, integrated circuits use conductive interconnect layers or levels formed on the wafer frontside to provide connect signal and power delivery routing to integrated circuits, but as semiconductor fabrication processes advance toward future nodes with shrinking interconnect stacks, there are increasingly resistance, capacitance, and power consumption issues which arise with using the conductive interconnects on the wafer frontside for both power and signal routing. When the power demand becomes too great, existing solutions have sought to enhance the conductivity of the conductive power supply interconnects, such as by adding more metal levels, making the Alucap (AP) final metallization thicker, or switching to copper pillar arrangements which allow power to be more directly delivered throughout the die, as opposed to wirebonding which is typically only from the chip periphery. In recent years, on-chip power delivery has been improved by decoupling the signal and power delivery routing to the integrated circuits can be decoupled by moving the power wiring to the wafer backside while signal routing is kept in the traditional wafer frontside. However, there are challenges with introducing power signal routing on the wafer backside, including potential interference with backside circuit elements (e.g., decoupling capacitors), processing challenges with creating through silicon via (TSV) interconnects structures in a semiconductor substrate material, process compatibility with wafer front-end-of-line (FEOL) and back-end-of-line (BEOL) wafer fabrication or alternatively for silicon-based package solutions. Further limitations and disadvantages of conventional processes and technologies will become apparent to one of skill in the art after reviewing the remainder of the present application with reference to the drawings and detailed description which follow.
US 2022/0293513 A1 discloses a device including a front side metallization portion having a front side BEOL. The device also includes a backside BEOL. The device also includes a substrate, where the substrate is disposed between the backside BEOL and the front side metallization portion. The device also includes a metal-insulator-metal capacitor embedded in the backside BEOL.
US 2002/0020862 A1 discloses a backside interconnect structure used to deliver power through a substrate to the front side of an integrated circuit. One or more power planes are formed on the backside of the substrate and coupled to power nodes on the front side by deep vias in the substrate. Power planes are coupled through the substrate to front side metal lines, well taps and external connection points.

### SUMMARY

According to the invention there is provided a method and an integrated circuit, as defined by the appended claims.

### BRIEF DESCRIPTION OF THE DRAWINGS

The present invention may be understood, and its numerous objects, features and advantages obtained, when the following detailed description of a preferred embodiment is considered in conjunction with the following drawings.
Figures 1-12 illustrate cross-sectional views at different stages of manufacture of a semiconductor structure having separate backside ground and power connection lines in accordance with selected first embodiments of the present disclosure.
Figures 13-14 illustrate cross-sectional views at different stages of manufacture of a semiconductor structure having separate backside ground and power connection lines in accordance with selected second embodiments of the present disclosure.
Figures 15-27 illustrate cross-sectional views at different stages of manufacture of a semiconductor structure having separate backside ground and power connection lines in accordance with selected third embodiments of the present disclosure.
Figure 28 illustrates a simplified process flow fabricating separate backside ground and power connection lines in accordance with selected embodiments of the present disclosure.

### DETAILED DESCRIPTION

An integrated circuit fabrication process and resulting integrated circuit are described for fabricating selective backside power and ground distribution conductors with backside conductive through silicon via (TSV) structures which are integrated with the decoupling capacitors plates to maximize the power and ground distribution in a die and decoupling capacitor area while providing a highly effective Electromagnetic Interference (EMI) shield. In selected embodiments, the backside power and ground distribution conductors are fabricated after substantial completion of the FEOL and BEOL wafer processing steps by sequentially forming first and second decoupling capacitor plates separated by a capacitor dielectric layer on the backside of the wafer, and then selectively forming conductive power and ground TSV structures in the wafer substrate layer which separately connect the first and second decoupling capacitor plates to buried power rails and other features formed in or on the wafer substrate layer. In selected first embodiments, one or more first TSV openings are etched through the backside wafer to expose a buried Vdd region or power rail/conductor feature in the wafer substrate layer and then lined with a dielectric layer and capped before etching one or more second TSV openings through the backside wafer to expose a ground region in the wafer substrate layer. Subsequently, the first and second TSV openings are partially filled with one or more electroplating layers to make direct electrical contact with the first decoupling capacitor plate, followed by selectively forming a patterned dielectric liner layer in the remaining first and second TSV openings which protects the electroplating layer(s) in the second TSV opening(s) while exposing the electroplating layer(s) in the first TSV opening(s) so that a subsequent metal electroplating process may fill the first and second TSV openings to make direct electrical contact between the second decoupling capacitor plate and the electroplating layer(s) in the first TSV opening(s) but not the first decoupling capacitor plate.

In selected second embodiments, the first and second TSV openings are partially filled with one or more electroplating layers to make direct electrical contact with the first decoupling capacitor plate but not the second decoupling capacitor plate. Subsequently, a patterned dielectric liner layer is selectively formed on the wafer backside and in the remaining first and second TSV openings which exposes the electroplating layer(s) in the first and second TSV openings. With the electroplating layers exposed and the first and second decoupling capacitor plates otherwise protected by the patterned dielectric liner layer, first and second patterned metal layers may be subsequently formed to fill the first and second TSV openings to make direct electrical contact with, respectively, the electroplating layer(s) in the first and second TSV openings but not the first and second decoupling capacitor plates.

In selected third embodiments, the first and second TSV openings are simultaneously etched through the backside wafer to expose buried metal features in the wafer substrate layer, followed by selectively forming a first patterned dielectric liner layer in the first and second TSV openings which exposes the buried metal features. Subsequently, one or more electroplating layers are formed which partially fill the first and second TSV openings without contacting the first and second decoupling capacitor plates, followed by forming one or more sacrificial dielectric layers to partially fill the first and second TSV openings in a position that is at least partially aligned with the first decoupling capacitor plate. With the sacrificial dielectric layer(s) in place, a second patterned dielectric liner layer is selectively formed as an etch mask in the remaining first and second TSV openings which protects the second decoupling capacitor plate while exposing the sacrificial dielectric layer(s) in the first and second TSV openings. Subsequently, one or more selective etch processes are selectively applied to remove the sacrificial dielectric layer(s) from the first and second TSV openings, and to expose the first decoupling capacitor plate in only the second TSV opening(s). With the electroplating layers being exposed in the first and second TSV openings, as well as the first decoupling capacitor plate being exposed in the second TSV opening and the second decoupling capacitor plate being exposed on the wafer backside, one or more first patterned metal layers may be subsequently formed to fill the first TSV opening(s) to make direct electrical contact between the electroplating layer(s) in the first TSV opening(s) and the second decoupling capacitor plate that is exposed on the wafer backside, but not the first decoupling capacitor plate. In addition, one or more second patterned metal layers may be subsequently formed to fill the second TSV opening(s) to make direct electrical contact between the electroplating layer(s) in the second TSV opening(s) and the first decoupling capacitor plate, but not the second decoupling capacitor plate.

In this disclosure, an improved integrated circuit design, structure, and method of manufacture are described for forming backside power and ground distribution conductors as part of, or after, the back-end-of-line process to address various problems in the art where various limitations and disadvantages of conventional solutions and technologies will become apparent to one of skill in the art after reviewing the remainder of the present application with reference to the drawings and detailed description provided herein. Various illustrative embodiments of the present invention will now be described in detail with reference to the accompanying figures. While various details are set forth in the following description, it will be appreciated that the present invention may be practiced without these specific details, and that numerous implementation-specific decisions may be made to the invention described herein to achieve the device designer's specific goals, such as compliance with process technology or design-related constraints, which will vary from one implementation to another. While such a development effort might be complex and time-consuming, it would nevertheless be a routine undertaking for those of ordinary skill in the art having the benefit of this disclosure. For example, selected aspects are depicted with reference to simplified cross sectional drawings of a semiconductor device without including every device feature or geometry in order to avoid limiting or obscuring the present invention. Such descriptions and representations are used by those skilled in the art to describe and convey the substance of their work to others skilled in the art. It is also noted that, throughout this detailed description, certain elements in the figures are illustrated for simplicity and clarity and have not necessarily been drawn to scale. In addition, the dimensions of some of the elements in the figures may be exaggerated relative to other elements to help improve the understanding of the embodiments of the present disclosure. Further, reference numerals have been repeated among the drawings to represent corresponding or analogous elements. In addition, the depicted device layers that are shown as being deposited and/or etched are represented with simplified line drawings, though it will be appreciated that, in reality, the actual contours or dimensions of device layers will be non-linear, such as when the described etch processes are applied at different rates to different materials, or when the described deposition or growth processes generate layers based on the underlaying materials.

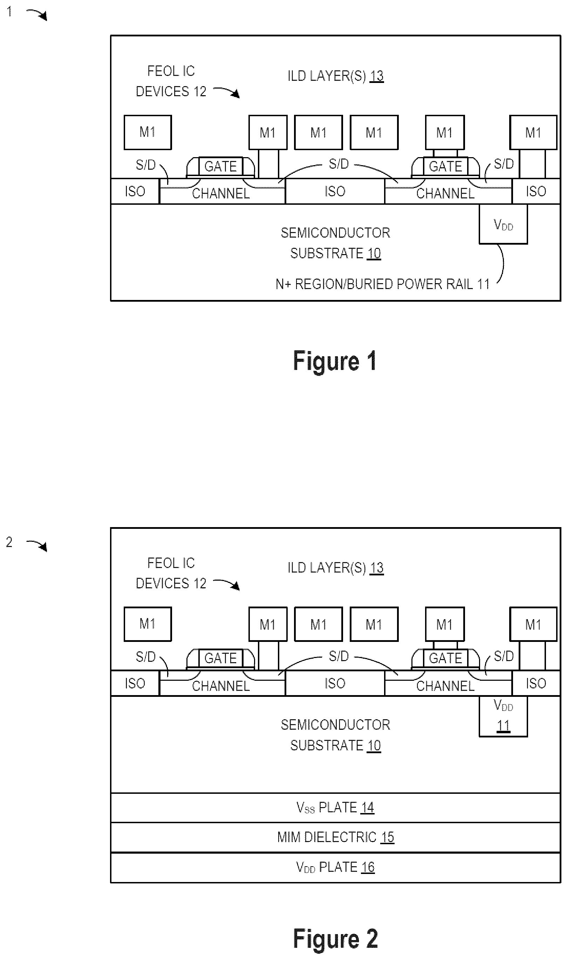

Various illustrative embodiments of the present invention will now be described in detail with reference to Figures 1-28. In addition, although specific example materials, thicknesses, and processes are described herein, those skilled in the art will recognize that other materials, thicknesses, and processes with similar properties or characteristics can be substituted without loss of function. It is noted that, throughout this detailed description, certain layers of materials will be deposited and removed to form the semiconductor structure. Where the specific procedures for processing such layers or thicknesses of such layers are not detailed below, conventional techniques known to one skilled in the art for depositing, removing, forming, or otherwise processing such layers at appropriate thicknesses shall be intended. Such details are well known and not considered necessary to teach one skilled in the art how to make or use the present invention.

Turning now to Figure 1, there is illustrated in cross-sectional form a portion of a semiconductor structure 1 having one or more inter-layer dielectric (ILD) layers 13 and a first metal line conductor layer M1 formed over a semiconductor substrate 10 in which one or more integrated circuit (IC) devices or elements 12 are fabricated with front-end-of-line (FEOL) wafer processing steps. As will be appreciated, the FEOL IC devices 12 may include one or more transistors, resistors, capacitors, diodes, or other semiconductor components that are formed on or in a semiconductor substrate that can be formed with any suitable semiconductor material or combinations of materials, such as gallium arsenide, silicon germanium, semiconductor-on-insulator (SOI), silicon, monocrystalline silicon, and the like. For example, the depicted transistors include gates formed over source/drain regions of a channel, where the transistors are separated from one another by isolation regions (ISO) and connected to patterned first metal line conductor layers M1 formed in the ILD layer(s) 13. In addition, the substrate 10 may include one or more Vdd regions, such as an N+ region or buried power rail structure which may be formed with any suitable conductive material, such as a metal layer or conductive implants. As illustrated, the FEOL IC devices 12 are formed on the top or front side of the semiconductor structure 1, and not on the wafer backside. In addition, the depicted semiconductor substrate 10 may have a specified thickness (e.g., 30 um) that is achieved by applying a wafer back grind process.

Figure 2 illustrates processing of the semiconductor structure 2 subsequent to Figure 1 after sequentially forming, on the wafer backside, first and second decoupling capacitor plates 14, 16 that are separated by a capacitor dielectric layer 15 in accordance with selected embodiments of the present disclosure. As an initial step, the first decoupling capacitor plate 14 may be formed as a Vss plate layer over the bottom or backside of the semiconductor substrate layer 10 to a predetermined thickness, such as by depositing a conductive material (e.g., copper, silver, aluminum, graphene, etc.) using any suitable deposition technique, such as chemical vapor deposition (CVD), plasma-enhanced chemical vapor deposition (PECVD), physical vapor deposition (PVD), atomic layer deposition (ALD), atmospheric pressure CVD (AP-CVD), chemical bath deposition (CBD), or any combination(s) of the above. In other embodiments, the first decoupling capacitor plate 14 may be formed with a Nickel plate layer that is surrounded with blanket films of Si3N4 or other suitable dielectric. On the first decoupling capacitor plate 14, the capacitor dielectric layer 15 may be formed as a metal-insulator-metal (MIM) dielectric on the first decoupling capacitor plate 14 to a predetermined thickness, such as depositing a high-k dielectric layer (e.g., TaN) or other suitable insulating material using any suitable deposition technique. On the capacitor dielectric layer 15, the second decoupling capacitor plate 16 may be formed as a Vdd plate layer on the capacitor dielectric layer 15 to a predetermined thickness, such as by depositing a conductive material (e.g., tantalum) using any suitable deposition technique, thereby forming a metal-insulator-metal (MIM) capacitor on the wafer backside.

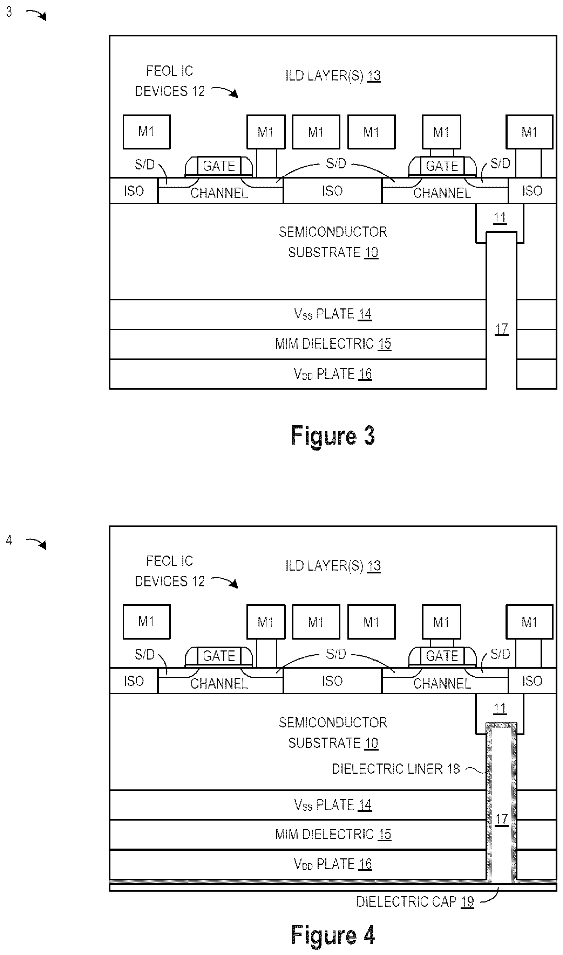

Figure 3 illustrates processing of the semiconductor structure 3 subsequent to Figure 2 after one or more anisotropic etch processes are applied to create one or more first through silicon via (TSV) openings 17 through the backside wafer to expose the buried Vdd region 11 or other power rail/conductor feature in the wafer substrate layer in accordance with selected embodiments of the present disclosure. While any suitable anisotropic etch process(es) may be used, the etch processing can use a patterned photoresist mask (not shown) with an opening exposing the intended etch region, and then performing a reactive-ion etching (RIE) step having suitable etch chemistry properties to remove the exposed portions of the underlying Vdd plate 16, MIM dielectric layer 15, Vss plate 14, and semiconductor substrate 10. For example, a controlled photo etch process, such as a timed anisotropic dry etch, may be used to remove a portion of the exposed portions of the underlying layers 10, 14, 15, 16 to a predetermined depth which exposes the buried Vdd region 11. Alternatively, the etch process(es) may be stopped by a silicon nitride layer (not shown) or they proceed into the ILD layer(s) 13 to connect to one of the patterned first metal line conductor layers M1 or other middle-end-of-line (MEOL) features, such as a contact. While the sidewalls of the TSV etch opening 17 are substantially vertical, it will be appreciated that minor deviations in the sidewall profile may occur due to etch processing variations.

Figure 4 illustrates processing of the semiconductor structure 4 subsequent to Figure 3 after the one or more first TSV openings 17 are lined with a dielectric liner layer 18 and then covered with a dielectric capping layer 19 in accordance with selected embodiments of the present disclosure. For example, the dielectric liner layer 18 may be formed by conformally depositing a suitable low-k dielectric layer (e.g., Si3N4) to a predetermined thickness using any suitable deposition technique. As a result, the dielectric liner layer 18 covers the wafer backside and the bottom and sidewalls of the one or more first TSV openings 17. After forming the dielectric liner layer 18, a blanket dielectric TSV-hole capping layer 19 is formed using any suitable deposition technique to cover and seal the first TSV opening(s) 17. For example, a layer of tetraethylorthosilicate (TEOS) may be deposited with a PECVD process at high pressure so that the dielectric TSV-hole capping layer 19 seals the etched TSV openings 17 by bread-loafing. In place of the capping dielectric layer 19, the TSV hole may be filled with a liquid spin-on polymeric or organic material which also coats the back surface.

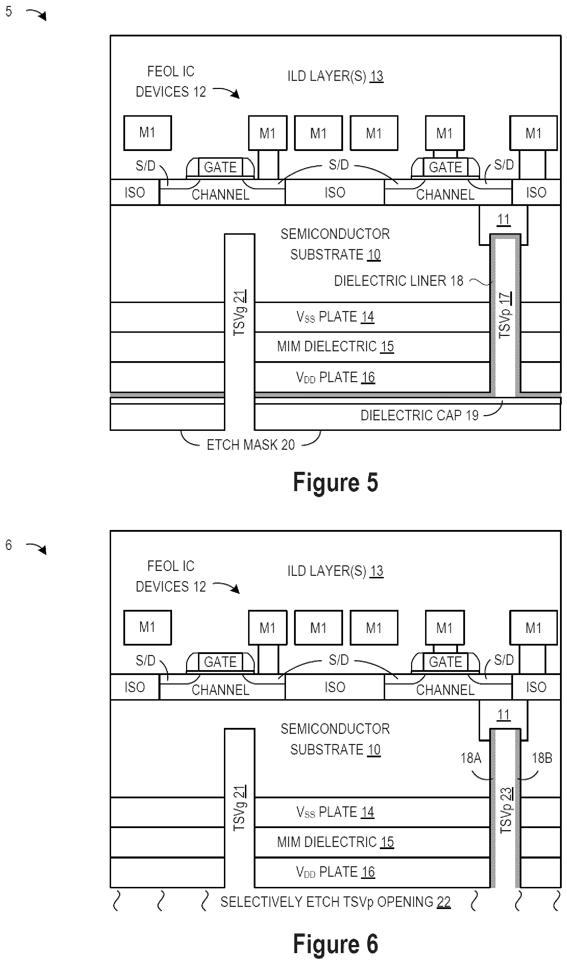

Figure 5 illustrates processing of the semiconductor structure 5 subsequent to Figure 4 after one or more anisotropic etch processes are applied to create one or more second TSV openings 21 through the backside wafer to expose the semiconductor substrate layer 10 in accordance with selected embodiments of the present disclosure. While any suitable anisotropic etch process(es) may be used, the etch processing can use a patterned photoresist etch mask 20 formed on the dielectric capping layer 19 to protect the wafer backside except for a mask opening exposing the intended etch region, and then performing a RIE step having suitable etch chemistry properties to remove the exposed portions of the underlying dielectric capping layer 19, dielectric liner 18, Vdd plate 16, MIM dielectric layer 15, Vss plate 14, and semiconductor substrate 10. For example, the one or more second TSV openings 21 may be formed with a controlled photo etch process, such as a timed anisotropic dry etch, and/or may use a silicon nitride layer (not shown) to stop the anisotropic etching, and/or proceed into the ILD layer(s) 13 to connect to one of the patterned first metal line conductor layers M1 or other middle-end-of-line (MEOL) features, such as a contact. While the sidewalls of the TSV etch opening 21 are substantially vertical, it will be appreciated that minor deviations in the sidewall profile may occur due to etch processing variations. As a result, the second TSV opening(s) 21 exposes the semiconductor substrate 10 where the ground TSVg 21 will be formed

Figure 6 illustrates processing of the semiconductor structure 6 subsequent to Figure 5 after selectively removing the dielectric liner 18 from the bottom of the first TSV opening(s) 17 with one or more selective etch process(es) 22 in accordance with selected embodiments of the present disclosure. While any suitable selective etch process(es) 22 may be used, the processing may include removing the patterned etch mask 20 and dielectric capping layer 19 from the wafer backside with one or more suitable etch chemistries, and then applying an anisotropic or directional etch which removes the dielectric liner layer 18 from the horizontal surfaces (e.g., the wafer backside and bottom of the first TSV opening(s) 17) while leaving the dielectric liner layer 18 on the vertical surfaces (e.g., sidewalls of the first TSV opening(s) 17). As a result, the first TSV opening(s) 23 exposes the buried Vdd region 11 where the power TSVp 23 will be formed.

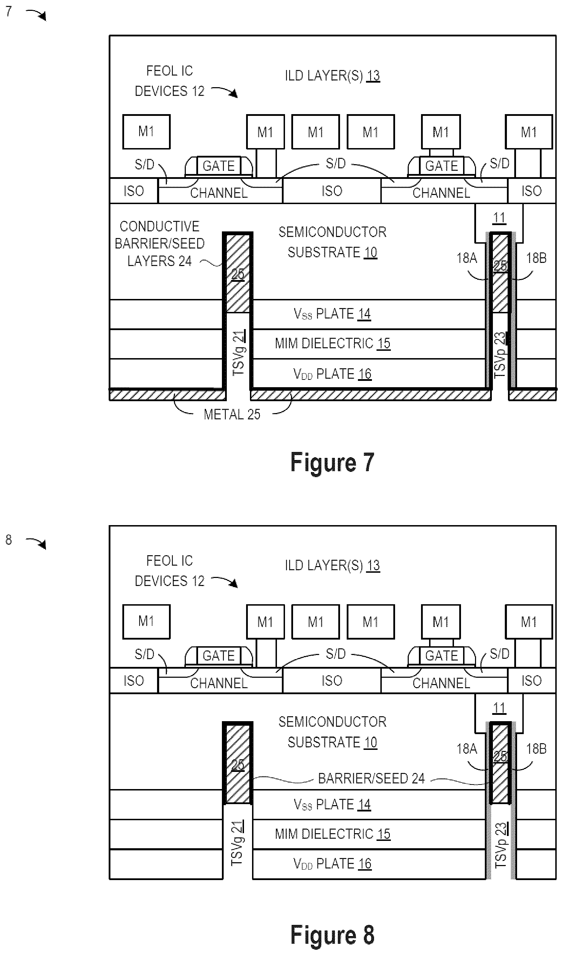

Figure 7 illustrates processing of the semiconductor structure 7 subsequent to Figure 6 after the first and second TSV openings 21, 23 are partially filled with one or more conductive TSV structures 24, 25 to make direct electrical contact with the first decoupling capacitor plate 14 in accordance with selected embodiments of the present disclosure. In selected embodiments, the conductive TSV structures are formed by first depositing a conductive barrier film or liner layer 24 formed of any suitable diffusion barrier material which also allows for electrodeposition (e.g., Ti, TiN, Ta, TaN, TiN, TiC, TaC, CuWP, or the like). As part of the conductive barrier film/liner layer, one or more conductive seed layers may be formed with any suitable conductive material, such as copper, a copper alloy, silver, gold, tungsten, aluminum, or the like. In selected embodiments, the conductive TSV structures may be formed by blanket depositing a barrier film in the TSV openings 21, 23, followed by depositing a thin seed layer (e.g., copper or copper alloy, nickel, etc.) over the barrier film, and then partially filling the TSV openings 21, 23 with metallic material 25, such as by using electro-plating, electroless plating, or depositing a conductive material (e.g., Cu, Co, Ni, Mn, Mg, Zn, Al, etc.). The electro-plating process may be controlled to provide a bottom-up partial electroplating so that the metallic material 25 is formed only on horizontal surfaces to cover the wafer backside and the bottom of the TSV openings 21, 23 and to make direct electrical contact with the first decoupling capacitor plate 14, but not the second decoupling capacitor plate 15.

Figure 8 illustrates processing of the semiconductor structure 8 subsequent to Figure 7 after selectively removing exposed portions of the conductive barrier/seed layer 24 from the wafer backside and exposed sidewalls of the TSV opening(s) 21, 23 in accordance with selected embodiments of the present disclosure. While any suitable selective removal etch process(es) may be used, the processing may include removing the metal layer 25 from the wafer backside, such as by using a chemical-mechanical polishing (CMP) step, thereby exposing the conductive barrier/seed layer 24 on the second decoupling capacitor plate 16. Alternatively, the metal layer 25 may be prevented forming on the wafer backside in the first place by forming a patterned photoresist layer to cover the wafer backside except for the TSV openings 21, 23 prior to the electroplating process used to partially fill the TSV openings 21, 23, and then removing the patterned photoresist layer to expose the conductive barrier/seed layer 24 on the second decoupling capacitor plate 16 with one or more suitable etch and/or polish steps. Subsequently, an isotropic etch may be applied to remove the exposed portions of the conductive barrier/seed layer 24 from the wafer backside and sidewalls of the TSV openings 21, 23. As a result, the first TSV opening(s) 23 retain the remnant dielectric liner layers 18A, 18B which protect the first and second decoupling capacitor plates 14, 16, but the second TSV opening(s) 21 expose the first and second decoupling capacitor plates 14, 16.

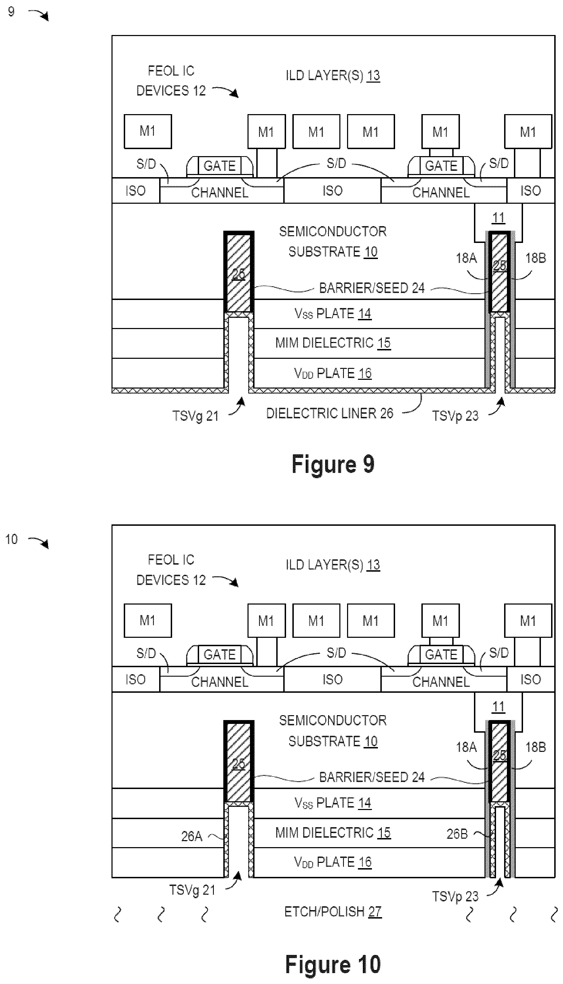

Figure 9 illustrates processing of the semiconductor structure 9 subsequent to Figure 8 after the first and second TSV openings 21, 23 are lined with a conformal dielectric layer 26 in accordance with selected embodiments of the present disclosure. For example, the conformal dielectric layer 26 may be formed by depositing a suitable low-k dielectric layer (e.g., Si3N4, SiO2) to a predetermined thickness using atomic layer deposition (ALD) or any other suitable deposition technique. As a result, the conformal dielectric layer 26 covers the wafer backside and the bottom and sidewalls of the first and second TSV openings 21, 23.

Figure 10 illustrates processing of the semiconductor structure 100 subsequent to Figure 9 after an etch and/or polish step 27 is applied to selectively remove the conformal dielectric layer 26 from the wafer backside but not the TSV opening(s) 21, 23 in accordance with selected embodiments of the present disclosure. While any suitable selective etch/polish process(es) 27 may be used, the processing may include removing the conformal dielectric layer 26 from the wafer backside with a CMP step or a patterned mask and selective etch process, thereby exposing the second decoupling capacitor plate 16.

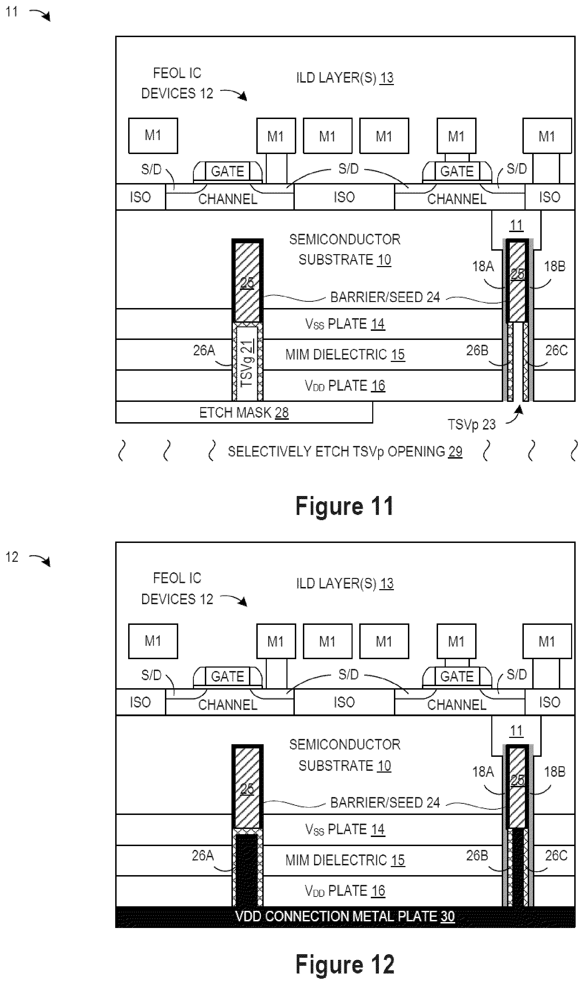

Figure 11 illustrates processing of the semiconductor structure 11 subsequent to Figure 10 after selectively removing the conformal dielectric layer 26 from the bottom of the first TSV opening(s) 23 with one or more selective etch process(es) 29 in accordance with selected embodiments of the present disclosure. While any suitable selective etch process(es) 29 may be used, the processing may include forming a patterned etch mask 28 to cover the second TSV opening(s) 21, and then applying an anisotropic or directional etch which removes the conformal dielectric layer 26 from the bottom of the first TSV opening(s) 23 while leaving the conformal dielectric layers 26A-C on the vertical sidewall surfaces of the first TSV opening(s) 23. As a result, the conductive TSV structure 25 in the first TSV opening(s) 23 is exposed.

Figure 12 illustrates processing of the semiconductor structure 12 subsequent to Figure 11 after the first and second TSV openings 21, 23 are filled with one or more conductive layers to form a Vdd connection metal plate 30 in direct electrical contact with the buried Vdd region 11 and second decoupling capacitor plate 16 in accordance with selected embodiments of the present disclosure. In selected embodiments, the Vdd connection metal plate 30 is formed by first depositing a conductive barrier film or liner layer formed with any suitable diffusion barrier material which also allows for electrodeposition (e.g., Ti, TiN, Ta, TaN, TiN, TiC, TaC, CuWP, or the like). In addition, one or more conductive seed layers may be formed on the conductive barrier film/liner layer with any suitable conductive material (e.g., copper, a copper alloy, silver, gold, tungsten, aluminum, or the like), followed by filling the TSV openings 21, 23 with metallic material using electro-plating, electroless plating, or depositing a conductive material (e.g., Cu, Co, Ni, Mn, Mg, Zn, Al, etc.). The resulting Vdd connection metal plate 30 is formed on the wafer backside in direct contact with the second decoupling capacitor plate 16 and the conductive TSV structures 25 in the TSVp openings 23, but not with the second decoupling capacitor plate 15. As will be appreciated, a separate Vss connector (not shown) is routed separately through the semiconductor structure to connect to the first decoupling capacitor plate 14 and the conductive TSV structures 25 in the TSVg openings 21.

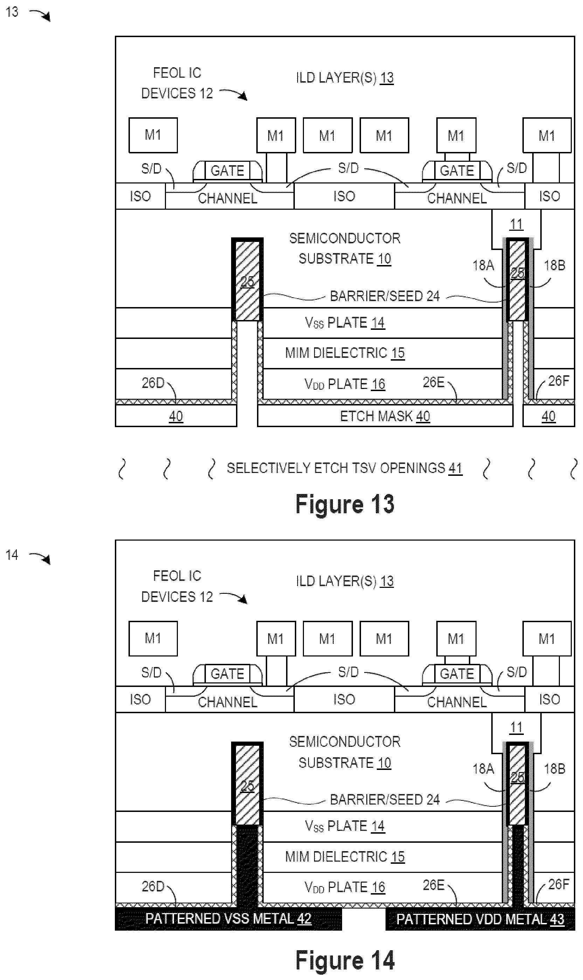

To provide a further improvement in the fabrication of separate backside ground and power connection lines, reference is now made to Figure 13 which depicts a partial cross-sectional view of a semiconductor structure subsequent to Figure 10 after selectively removing the conformal dielectric layer 26 from the bottoms of both the first and second TSV openings 21, 23 with one or more selective etch process(es) 41 in accordance with selected embodiments of the present disclosure. While any suitable selective etch process(es) 41 may be used, the processing may include forming a patterned etch mask 40 to cover the wafer backside except for mask openings over the first and second TSV openings 21, 23, and then applying an anisotropic or directional etch which removes the conformal dielectric layer 26 from the bottom of the first and second TSV openings 21, 23 while leaving the conformal dielectric layer 26D-F on the wafer backside and exposed vertical sidewall surfaces of the first and second TSV openings 21, 23. As a result, the conductive TSV structures 25 in the first and second TSV openings 21, 23 are both exposed.

Figure 14 illustrates processing of the semiconductor structure 14 subsequent to Figure 13 after forming a patterned Vss metal layer 42 and Vdd metal layer 43 in the first and second TSV openings 21, 23 in accordance with selected embodiments of the present disclosure. In selected embodiments, the patterned metal layers 42, 43 are formed by filling the first and second TSV openings 21, 23 with one or more conductive layers, and then applying a patterned etch process to simultaneously form the patterned Vss metal layer 42 and Vdd metal layer 43 in direct electrical contact with the conductive TSV structures 25 in the TSV openings 21, 23. In selected embodiments, the patterned metal layers 42, 43 are formed by first depositing a conductive barrier film or liner layer formed in the TSV openings 21, 23 with any suitable diffusion barrier material which also allows for electrodeposition (e.g., Ti, TiN, Ta, TaN, TiN, TiC, TaC, CuWP, or the like). In addition, one or more conductive seed layers may be formed on the conductive barrier film/liner layer with any suitable conductive material (e.g., copper, a copper alloy, silver, gold, tungsten, aluminum, or the like), followed by filling the TSV openings 21, 23 with metallic material using electro-plating, electroless plating, or depositing a conductive material (e.g., Cu, Co, Ni, Mn, Mg, Zn, Al, etc.). The deposited conductive layers are then patterned and etched using any suitable selective etch process(es) to form the patterned Vss metal layer 42 and Vdd metal layer 43 on the wafer backside in direct contact with, respectively, the first decoupling capacitor plate 14/semiconductor substrate 10 (via the conductive TSV structure 25 in the TSVg opening 21) and the buried Vdd region 11 (via the conductive TSV structure 25 in the TSVp opening 23). As will be appreciated, a separate Vdd connector (not shown) is routed separately through the semiconductor structure to connect to the second decoupling capacitor plate 16 and the conductive TSV structures 25 in the TSVp openings 23.

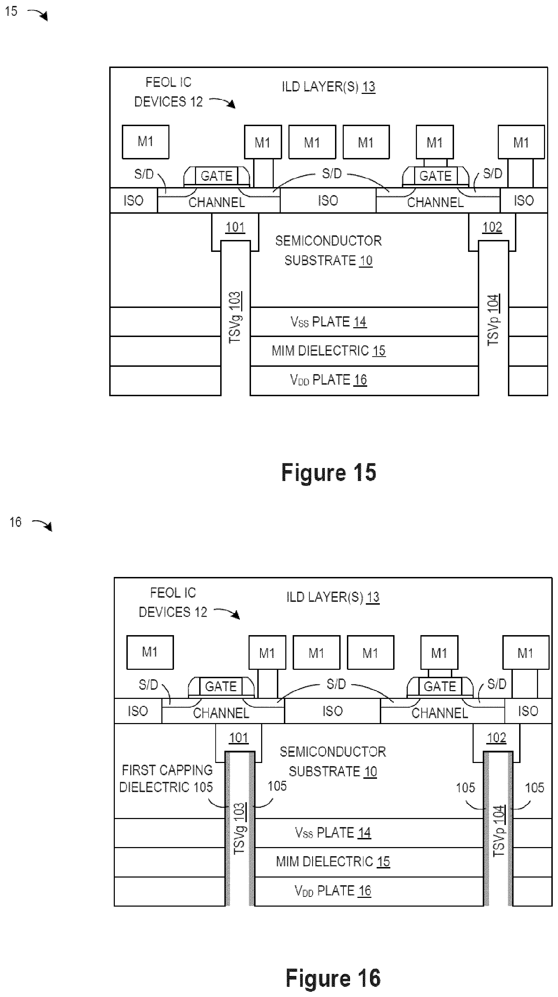

To provide a further improvement in the fabrication of separate backside ground and power connection lines, reference is now made to Figure 15 which depicts a partial cross-sectional view of a semiconductor structure subsequent to Figure 2 after one or more anisotropic etch processes are applied to simultaneously create first and second TSV openings 103, 104 through the backside wafer to expose buried metal features 101, 102 in the wafer substrate layer in accordance with selected embodiments of the present disclosure. While any suitable anisotropic etch process(es) may be used, the etch processing can use a patterned photoresist mask (not shown) with openings exposing the intended etch regions, and then performing a RIE) step having suitable etch chemistry properties to remove the exposed portions of the underlying Vdd plate 16, MIM dielectric layer 15, Vss plate 14, and semiconductor substrate 10. For example, the one or more second TSV openings 21 may be formed with a controlled photo etch process, such as a timed anisotropic dry etch, and/or may use a silicon nitride layer (not shown) to stop the anisotropic etching, and/or proceed into the ILD layer(s) 13 to connect to one of the patterned first metal line conductor layers M1 or other middle-end-of-line (MEOL) features, such as a contact. While the sidewalls of the TSV etch openings 103, 104 are substantially vertical, it will be appreciated that minor deviations in the sidewall profile may occur due to etch processing variations.

Figure 16 illustrates processing of the semiconductor structure 16 subsequent to Figure 15 after selectively forming a first capping dielectric layer 105 on the sidewalls of TSV openings 103, 104 in accordance with selected embodiments of the present disclosure. For example, the first capping dielectric layer 105 may be formed by conformally depositing a suitable low-k dielectric layer (e.g., Si3N4) to a predetermined thickness using any suitable deposition technique to cover the wafer backside and the bottom and sidewalls of the TSV openings 103, 104. After forming the first capping dielectric layer 105, one or more selective etch process(es) may be applied to remove the first capping dielectric layer 105 from the bottom of the TSV openings 103, 104. For example, an anisotropic or directional etch may be applied to remove the first capping dielectric layer 105 from the horizontal surfaces (e.g., the wafer backside and bottom of the TSV openings 103, 104) while leaving the first capping dielectric layer 105 on the vertical surfaces (e.g., sidewalls of the TSV openings 103, 104). As a result, the TSV openings103, 104 expose the buried metal features 101, 102.

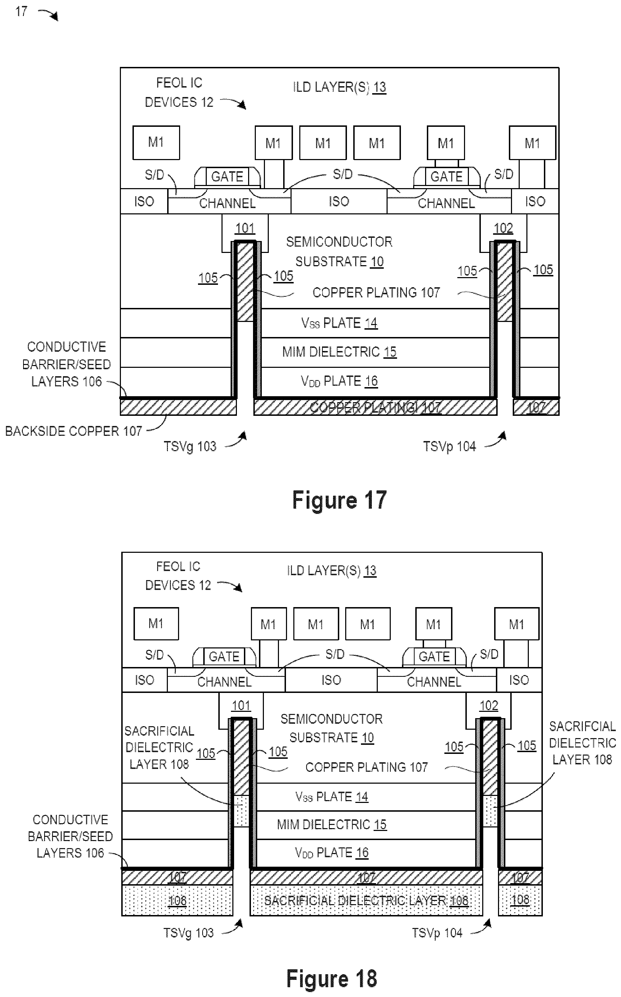

Figure 17 illustrates processing of the semiconductor structure 17 subsequent to Figure 16 after the first and second TSV openings 103, 104 are partially filled with one or more conductive TSV structures 106, 107 to make direct electrical contact with the first decoupling capacitor plate 14 in accordance with selected embodiments of the present disclosure. In selected embodiments, the conductive TSV structures are formed by first depositing a conductive barrier film/seed liner layer 106 formed of any suitable diffusion barrier material which also allows for electrodeposition (e.g., Ti, TiN, Ta, TaN, TiN, TiC, TaC, CuWP, or the like). As part of the conductive barrier film/seed liner layer 106, one or more conductive seed layers may be formed with any suitable conductive material, such as copper, a copper alloy, silver, gold, tungsten, aluminum, or the like. In selected embodiments, the conductive TSV structures may be formed by blanket depositing a barrier film in the TSV openings 103, 104, followed by depositing a thin seed layer (e.g., copper or copper alloy, nickel, etc.) over the barrier film, and then partially filling the TSV openings 103, 104 with a copper plating layer 107 or other suitable metallic material, such as by using electro-plating, electroless plating, or depositing a conductive material (e.g., Cu, Co, Ni, Mn, Mg, Zn, Al, etc.). The electro-plating process may be controlled to provide a bottom-up partial electroplating so that the copper plating layer 107 is formed only on horizontal surfaces to cover the wafer backside and the bottom of the TSV openings 103, 104 and to make direct electrical contact with the first decoupling capacitor plate 14, but not the second decoupling capacitor plate 15.

Figure 18 illustrates processing of the semiconductor structure 18 subsequent to Figure 17 after a sacrificial dielectric layer 108 is formed on the wafer backside and bottom of the first and second TSV openings 103, 104 in accordance with selected embodiments of the present disclosure. In selected embodiments, the sacrificial dielectric layer 108 is formed by anisotropically depositing a suitable dielectric layer (e.g., Si3N4, SiO2) to a predetermined thickness. Examples of such anisotropic deposition processes include, but are not limited to low-pressure CVD (LPCVD), low-pressure plasma-enhanced CVD (LP-PECVD), and the like. As a result, the sacrificial dielectric layer 108 is not formed on the sidewalls of the TSV openings 103, 104, but is formed on the wafer backside and on the bottom of the TSV openings 103, 104 to cover the copper plating layer 107 at the bottom of the TSV openings 103, 104. While the sacrificial dielectric layer 108 is shown as being deposited on the wafer backside copper plating layer 107, it will be appreciated that the wafer backside copper plating layer 107 can be removed, such as by using a CMP process or other suitable selective etch process so that the sacrificial dielectric layer 108 is formed directly on the second decoupling capacitor plate 16. In any case, the directionally deposited sacrificial dielectric layer 108 leaves exposed the conductive barrier/seed layer on the exposed sidewalls of the TSV openings 103, 104.

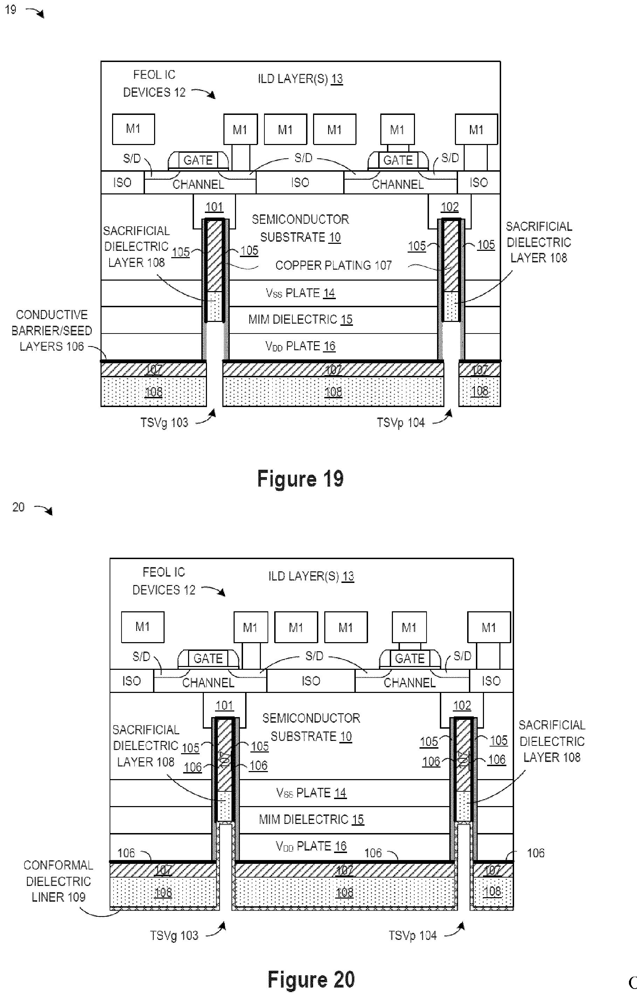

Figure 19 illustrates processing of the semiconductor structure 19 subsequent to Figure 18 after selectively removing exposed portions of the conductive barrier/seed layer 106 from the wafer backside and exposed sidewalls of the TSV opening(s) 103, 104 in accordance with selected embodiments of the present disclosure. While any suitable selective removal etch process(es) may be used, an isotropic etch may be applied which has suitable etch chemistry properties to remove the exposed portions of the conductive barrier/seed layer 106 from the wafer backside and sidewalls of the TSV openings 103, 104. As a result, the TSV opening 103, 104 retain the remnant dielectric liner layers 105 which protect the first and second decoupling capacitor plates 14, 16.

Figure 20 illustrates processing of the semiconductor structure 20 subsequent to Figure 19 after the first and second TSV openings 103, 104 are lined with a conformal dielectric liner layer 109 in accordance with selected embodiments of the present disclosure. For example, the conformal dielectric liner layer 109 may be formed by depositing a suitable low-k dielectric layer (e.g., Si3N4, SiO2) to a predetermined thickness using atomic layer deposition (ALD) or any other suitable deposition technique to cover the wafer backside and the bottom and sidewalls of the first and second TSV openings 103, 104.

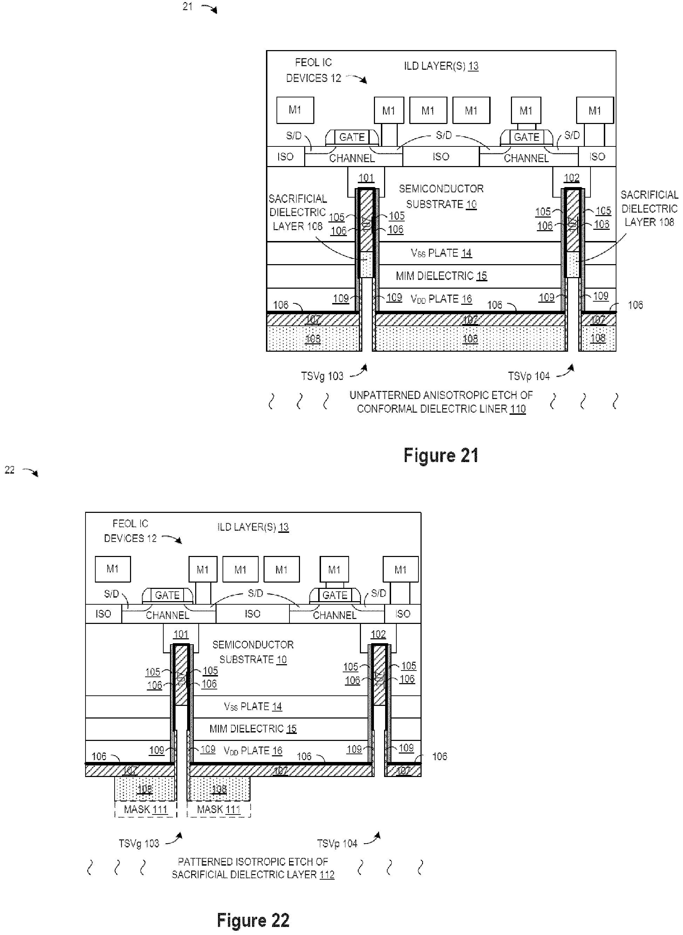

Figure 21 illustrates processing of the semiconductor structure 21 subsequent to Figure 20 after an un-patterned anisotropic etch process 110 is applied to selectively remove the conformal dielectric liner layer 109 from the wafer backside and the bottom of the TSV opening(s) 103, 104 in accordance with selected embodiments of the present disclosure. While any suitable selective etch process(es) 110 may be used, the processing may include applying an anisotropic or directional etch which removes the conformal dielectric liner layer 109 from the bottom of the TSV openings 103, 104 while leaving the conformal dielectric liner layer 109 on the vertical sidewall surfaces of the TSV openings 103, 104. As a result, the sacrificial dielectric layers 108 are exposed on the wafer backside and in the TSV openings 103, 104.

Figure 22 illustrates processing of the semiconductor structure 22 subsequent to Figure 21 after a patterned isotropic etch process 112 is applied to selectively remove the sacrificial dielectric layers 108 from at least the TSV openings 103, 104 in accordance with selected embodiments of the present disclosure. While any suitable selective etch process(es) 112 may be used, the processing may include forming a patterned etch mask 111 on the sacrificial dielectric layers 108 around the TSV opening 103, and then applying an isotropic etch which has suitable etch chemistry properties to remove exposed portions of the sacrificial dielectric layers 108 from the wafer backside and from the bottom of the TSV openings 103, 104 while leaving the copper plating layer 107 on the wafer backside and bottom of the TSV openings 103, 104. As a result, the conductive barrier film/seed liner layer 106 on the sidewalls of the TSV openings 103, 104 are exposed.

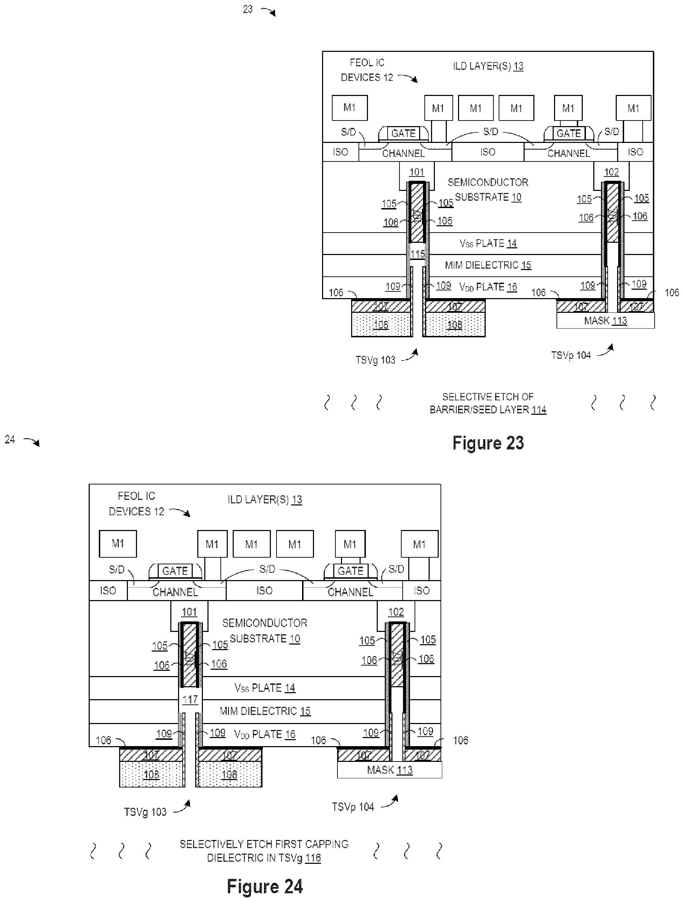

Figure 23 illustrates processing of the semiconductor structure 23 subsequent to Figure 22 after a selective etch process 114 is applied to selectively remove at least exposed portions of the conductive barrier film/seed liner layer 106 from the TSV openings 103 in accordance with selected embodiments of the present disclosure. While any suitable selective etch process(es) 114 may be used, the processing may include forming a patterned etch mask 113 on the copper plating layer 107 to cover the TSV opening 104. Using the patterned etch mask 113 and the remnant sacrificial dielectric layers 108 as an etch mask, an etch process may be applied which has suitable etch chemistry properties to remove exposed portions of the conductive barrier film/seed liner layer 106 from the wafer backside and from the exposed sidewalls of the TSV opening 103. As a result, the exposed conductive barrier film/seed liner layer 106 on the sidewalls of the TSV opening 103 are removed, thereby exposing at least a portion of the first capping dielectric layer 105.

Figure 24 illustrates processing of the semiconductor structure 24 subsequent to Figure 23 after a selective etch process 116 is applied to selectively remove at least the exposed first capping dielectric layer 105 on the sidewalls of the TSV opening 103 in accordance with selected embodiments of the present disclosure. While any suitable selective etch process(es) 116 may be used, the processing may use the patterned etch mask 113 and the remnant sacrificial dielectric layers 108 as an etch mask when applying an etch process which has suitable etch chemistry properties to remove exposed portions of the first capping dielectric layer 105 from the sidewalls of the TSV opening 103. As a result, the exposed first capping dielectric layer 105 on the sidewalls of the TSV opening 103 are removed, thereby forming an opening 117 in the TSV opening 103 that exposes at least a portion of the first decoupling capacitor plate 14.

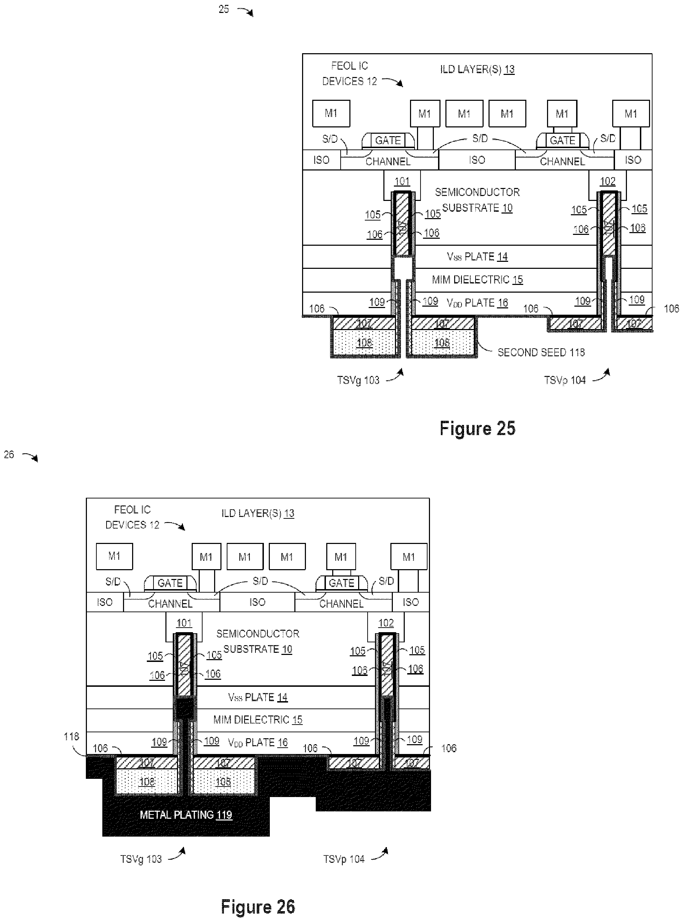

Figure 25 illustrates processing of the semiconductor structure 25 subsequent to Figure 24 after a second seed layer 118 is formed in the TSV openings 103, 104 to make direct electrical contact with the conductive TSV structures 106, 107 in accordance with selected embodiments of the present disclosure. For example, the second seed layer 118 may be formed by conformally depositing one or more conductive seed layers using any suitable conductive material (e.g., copper, a copper alloy, silver, gold, tungsten, aluminum, or the like) to a predetermined thickness using any suitable deposition technique.

Figure 26 illustrates processing of the semiconductor structure 26 subsequent to Figure 25 after a metal plating layer 119 is formed over the wafer backside and to fill the TSV openings 103, 104 in accordance with selected embodiments of the present disclosure. For example, the metal plating layer 119 may be formed by electro-plating, electroless plating, or depositing a conductive material (e.g., Cu, Co, Ni, Mn, Mg, Zn, Al, etc.) to a predetermined thickness using any suitable deposition technique.

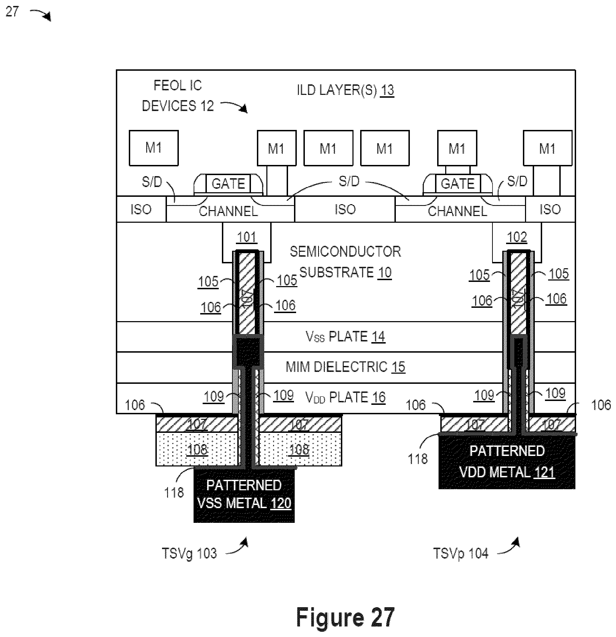

Figure 27 illustrates processing of the semiconductor structure 27 subsequent to Figure 26 after forming a patterned Vss metal layer 120 and patterned Vdd metal layer 121 in accordance with selected embodiments of the present disclosure. For example, the metal plating layer 119 may be patterned and etched using any suitable selective etch process(es) to form the patterned Vss metal layer 120 and Vdd metal layer 121 on the wafer backside. As formed, the patterned Vss metal layer 120 is electrically connected to the buried metal feature 101 and the first decoupling capacitor plate 14 via the conductive TSV structure 107 in the TSVg opening 103. In addition, the patterned Vdd metal layer 121 is electrically connected to the buried metal feature 102 via the conductive TSV structure 107 in the TSVp opening 104, and is also connected to the second decoupling capacitor plate 16 via the remnant copper plating layer 107 on the wafer backside.

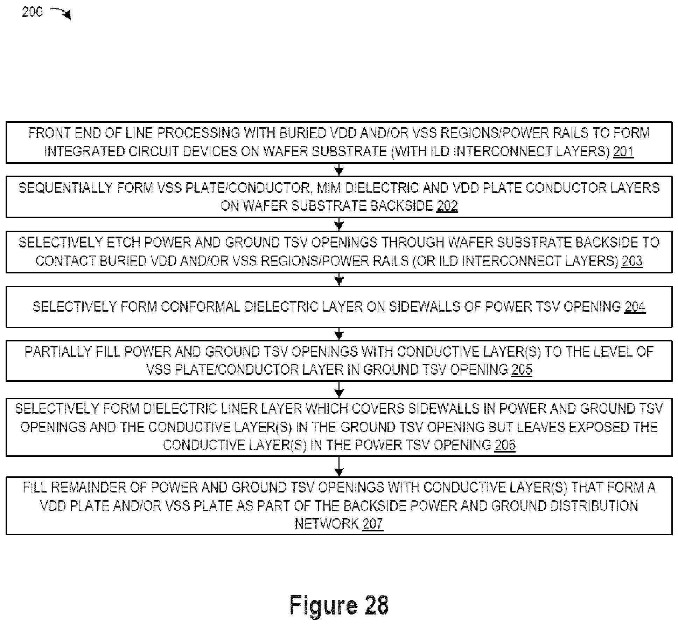

Turning now to Figure 28, there is illustrated a simplified process flow 200 for fabricating separate backside ground and power connection lines in accordance with selected embodiments of the present disclosure. Though selected embodiments of the backside ground and power connection fabrication methodology are described with reference to an example back-end-of-line fabrication process, it will be appreciated by persons skilled in the art that the sequence of illustrated steps may be used in any suitable stage of the device fabrication process, and may be modified, reduced or augmented in keeping with the disclosure of the present invention. Thus, it will be appreciated that the methodology of the present disclosure may be thought of as performing the identified sequence of steps in the order depicted in Figure 28, though the steps may also be performed in parallel, in a different order, or as independent operations that are combined.

The disclosed fabrication methodology begins with one or more front-end-of-line (FEOL) processing steps 201 which are used to fabricate a wafer substrate with buried Vdd and/or Vss regions and/or power rails that are connected to one or more integrated circuit elements (e.g., transistors, capacitors, resistors, diodes, etc.). Generally speaking, FEOL processing is the first portion of IC fabrication where the individual components (transistors, capacitors, resistors, etc.) are patterned in the semiconductor, and generally covers everything up to (but not including) the deposition of metal interconnect layers.

At step 202, a Vss plate conductor plate layer, MIM dielectric layer, and Vdd plate conductor layer are sequentially formed on the backside of the wafer substrate. In an example embodiment, the Vss plate conductor plate layer may be formed with a dielectric-plated nickel plate layer, though any suitable conductive material may be deposited to form the first decoupling capacitor plate. In addition, the MIM dielectric layer may be formed on the Vss plate conductor plate layer by depositing a high-k dielectric material (e.g., TaN). In addition, the Vdd plate conductor layer may be formed on the MIM dielectric layer by depositing a conductive material (e.g., Ta), though any suitable conductive material may be deposited to form the second decoupling capacitor plate.

At step 203, power and ground TSV openings may be selectively etched through the wafer substrate backside to contact the buried Vdd and/or Vss regions or power rails formed in the semiconductor substrate. In other embodiments, the power and ground TSV openings may be selectively etched through the wafer substrate to contact features in the ILD interconnect layers. As disclosed herein, the power and ground TSV openings can be formed simultaneously or sequentially by using any suitable masked etch process, such as by forming a patterned photoresist layer as an etch mask and then applying one or more anisotropic etch processes to etch through the Vss plate conductor plate layer, MIM dielectric layer, Vdd plate conductor layer and backside of the wafer substrate.

At step 204, a conformal dielectric layer is selectively formed on the sidewalls (but not on the bottom) of the power TSV opening. In an example embodiment, the selective formation of the conformal dielectric layer may include an initial step for depositing a conformal dielectric layer over the waver backside, followed by application of an anisotropic etch process which selectively removes the conformal dielectric layer from the bottom (but not the sidewalls) of the power TSV opening. In selected embodiments, the conformal dielectric layer may be formed with a photoimageable polyimide, or SiOx, SiCN, SixNy or combinations and variations may be used.

At step 205, power and TSV openings may be partially filled with one or more conductive layers. In an example embodiment, the one or more conductive layers may be formed by sequentially depositing a barrier liner layer, seed layer, and electroplating layer(s) in the power and TSV openings to a level of the Vss plate conductor plate layer in the ground TSV opening, but not the Vdd plate conductor plate layer. As disclosed herein, the barrier films may use any suitable diffusion barrier which also allows for electrodeposition, including but not limited to TiN, TaN, TiC, TaC, CuWP or similar or combinations. In addition, the electroplating metals may include Cobalt, Nickel, Copper, etc. Various combinations of these and slight additions of other metals such as Mn, Mg, Zn, Al, etch could be also employed.

At step 206, a dielectric liner layer is selectively formed which covers the sidewalls of the power and ground TSV openings and the one or more conductive layers in the ground TSV opening, but leaves exposed the one or more conductive layers in the power TSV opening. In an example embodiment, the selective formation of the dielectric liner layer may include an initial step for depositing a conformal dielectric liner layer over the waver backside, followed by application of a selective masking and/or etching processes which selectively remove the conformal dielectric liner layer to protect or cover the conductive layer(s) in the ground TSV opening and to expose the conductive layer(s) in the power TSV opening.

At step 207, the remainder of the power and TSV openings are filled with one or more conductive layers to cover the wafer backside and form a Vdd plate and/or Vss plate as part of the backside power and ground distribution network. In an example embodiment, the one or more conductive layers may be formed by sequentially depositing a seed layer and electroplating layer(s) in the power and TSV openings to fill the power and ground TSV openings and cover the wafer backside. The conductive layers may be planarized on the wafer backside to form the Vdd plate layer. In addition or in the alternative, the conductive layers may be patterned and etched to form the Vdd plate/conductor layer and/or the Vss plate/conductor layer.

As described hereinabove, the present disclosure provides a mechanism for integrating backside power and ground distribution network connections by adding through-silicon vias through the backside which are selectively filled with conductive layers using selective deposition and removal of passivation layers so that conductive TSV connectors electrically connect buried power lines or regions in the wafer substrate to decoupling capacitor plates of a uniform film, full-die decoupling MIM capacitor formed on the wafer backside. In addition to reducing fabrication cost and complexity for making power and ground connections, the disclosed backside power and ground distribution network reduces front-side metallization congestion, resistance, capacitance, and power consumption issues for routing power and ground signals through the substrate backside, while also providing improved EMI shielding from the decoupling capacitor plates and TSVs.

By now, it should be appreciated that there has been provided a semiconductor wafer with backside power and ground distribution network connections and associated method of fabrication. In the disclosed methodology, a semiconductor wafer is provided that contains a plurality of integrated circuit (IC) devices formed on a frontside of a semiconductor substrate layer in which integrated device connection features are formed. In selected embodiments, the integrated device connection features may be formed in the semiconductor substrate layer as a highly doped semiconductor connection region or buried power rail connection region formed in the semiconductor substrate layer. The disclosed methodology also includes forming a decoupling capacitor on a backside of the semiconductor substrate layer which includes a first capacitor plate, a capacitor dielectric layer, and a second capacitor plate. In selected embodiments, the decoupling capacitor may include a first decoupling capacitor plate formed to cover the backside of the semiconductor substrate layer, a high-k capacitor dielectric layer formed to cover the first decoupling capacitor plate, and a second decoupling capacitor plate formed to cover the high-k capacitor dielectric layer. In addition, the disclosed methodology includes selectively etching a plurality of through-semiconductor via (TSV) openings through the decoupling capacitor and the backside of the semiconductor substrate layer to contact the integrated device connection features. The disclosed methodology also includes forming, in a first TSV opening of each IC device, a first voltage supply (e.g., ground) TSV conductor which provides a direct electrical connection between the first capacitor plate and a first integrated device connection feature formed in the semiconductor substrate layer. In addition, the disclosed methodology includes forming, in a second TSV opening of each IC device, a second voltage supply (e.g., power) TSV conductor which provides a direct electrical connection between the second capacitor plate and a second integrated device connection feature formed in the semiconductor substrate layer. As formed, the ground TSV conductor is not directly, electrically connected to the second capacitor plate, and the power TSV conductor is not directly, electrically connected to the first capacitor plate. The disclosed methodology may also include singulating the semiconductor wafer into multiple integrated circuit die. In selected embodiments, the plurality of TSV openings are selectively etched to sequentially form the first and second TSV openings through the decoupling capacitor and the backside of the semiconductor substrate layer to contact the integrated device connection features. In such embodiments, the ground TSV conductor may be formed by partially filling the first TSV opening with one or more first conductive layers to form at least part of the ground TSV conductor in direct electrical connection between the first capacitor plate and the first integrated device connection feature; selectively forming an insulating dielectric layer in unfilled portions of the first TSV opening; and filling in unfilled portions of the first TSV opening with one or more second conductive layers, where the insulating dielectric layer prevents direct electrical connection between the ground TSV conductor and the second capacitor plate. In other such embodiments, the power TSV conductor may be formed by selectively forming a conformal dielectric layer on sidewalls but not bottom of the second TSV opening to leave exposed the second integrated device connection feature; partially filling the second TSV opening with one or more first conductive layers to form at least part of the power TSV conductor; and filling the second TSV opening with one or more second conductive layers to form the power TSV conductor, where the conformal dielectric layer prevents direct electrical connection between the power TSV conductor and the first capacitor plate. In other selected embodiments, the plurality of TSV openings are sequentially etched to simultaneously form the first and second TSV openings through the decoupling capacitor and the backside of the semiconductor substrate layer to contact the integrated device connection features. In such embodiments, the ground TSV conductor may be formed by selectively forming a conformal dielectric layer on sidewalls but not bottom of the first TSV opening to leave exposed the first integrated device connection feature; partially filling the first TSV opening with one or more first conductive layers to form at least part of the ground TSV conductor in direct electrical connection between the first capacitor plate and the first integrated device connection feature; selectively etching the conformal dielectric layer from a portion of the sidewalls of the first TSV opening to expose the first capacitor plate; and filling the first TSV opening with one or more second conductive layers, where unetched portions of the conformal dielectric layer prevent direct electrical connection between the ground TSV conductor and the second capacitor plate. In other such embodiments, the power TSV conductor may be formed by selectively forming a conformal dielectric layer on sidewalls but not bottom of the second TSV opening to leave exposed the second integrated device connection feature; partially filling the second TSV opening with one or more first conductive layers to form at least part of the power TSV conductor; and filling the second TSV opening with one or more second conductive layers to form the power TSV conductor, where the conformal dielectric layer prevents direct electrical connection between the power TSV conductor and the first capacitor plate.

In another form, there has been provided a semiconductor device with backside power and ground distribution conductors and associated method of fabrication. In the disclosed methodology, first and second decoupling capacitor plates separated by a capacitor dielectric layer are formed on a backside of the semiconductor device. In selected embodiments, the first and second decoupling capacitor plates may form an Electromagnetic Interference (EMI) shield on the backside of the semiconductor device. In addition, conductive through-silicon via (TSV) structures are selectively formed in the semiconductor device. As formed, the conductive TSV structures include a conductive first voltage supply (e.g., power) TSV structure which directly, electrically connects a Vdd power connection feature formed in the semiconductor device to the second decoupling capacitor plate, but not to the first decoupling capacitor plate. In addition, the conductive TSV structures include a conductive second voltage supply (e.g., ground) TSV structure which directly, electrically connects a Vss ground connection feature formed in the semiconductor device to the first decoupling capacitor plate, but not to the second decoupling capacitor plate. In selected embodiments, the Vdd power connection feature formed in the semiconductor device may be a highly doped semiconductor substrate connection region or a buried power rail connection region or a metal line conductor layer formed in one or more inter-layer dielectric (ILD) connection layers of the semiconductor device. Alternatively, the Vdd power connection feature and the VSS ground connection feature may each be formed with a buried metal layer formed in the semiconductor device. In selected embodiments, the conductive TSV structures may be selectively formed by selectively etching first and second TSV openings through the first and second decoupling capacitor plates separated by the capacitor dielectric layer on the backside of the semiconductor device to contact, respectively, the Vdd power connection feature and the Vss ground connection feature; forming the conductive power TSV structure in the first TSV opening to provide a direct electrical connection between the first decoupling capacitor plate and the Vdd power connection feature formed in the semiconductor device; and forming the conductive ground TSV structure in the second TSV opening to provide a direct electrical connection between the second decoupling capacitor plate and the Vss ground connection feature formed in the semiconductor device. In such embodiments, the conductive power TSV structure may be formed by selectively forming a conformal dielectric layer on sidewalls but not bottom of the first TSV opening to leave exposed the Vdd power connection feature; partially filling the first TSV opening with one or more first conductive layers to form at least part of the conductive power TSV structure; and filling the first TSV opening with one or more second conductive layers to form the conductive power TSV structure, where the conformal dielectric layer prevents direct electrical connection between the conductive power TSV structure and the first decoupling capacitor plate. In other such embodiments, the conductive ground TSV structure may be formed by partially filling the second TSV opening with one or more first conductive layers to form at least part of the conductive ground TSV structure in direct electrical connection between the first decoupling capacitor plate and the Vss ground connection feature; selectively forming an insulating dielectric layer in unfilled portions of the second TSV opening; and filling in unfilled portions of the second TSV opening with one or more second conductive layers, where the insulating dielectric layer prevents direct electrical connection between the conductive ground TSV structure and the second decoupling capacitor plate. In selected embodiments, the first and second TSV openings may be simultaneously etched through the first and second decoupling capacitor plates separated by the capacitor dielectric layer and the backside of the semiconductor device to contact, respectively, the Vdd power connection feature and the Vss ground connection feature. In such embodiments, the conductive ground TSV structure may be formed by selectively forming a conformal dielectric layer on sidewalls but not bottom of the second TSV opening to leave exposed the Vss ground connection feature; partially filling the second TSV opening with one or more first conductive layers to form at least part of the conductive ground TSV structure; selectively etching the conformal dielectric layer from a portion of the sidewalls of the second TSV opening to expose the first decoupling capacitor plate; and filling the second TSV opening with one or more second conductive layers in direct electrical connection with the first decoupling capacitor plate and the one or more first conductive layers, where unetched portions of the conformal dielectric layer prevent direct electrical connection between the conductive ground TSV structure and the second decoupling capacitor plate. In other such embodiments, the conductive power TSV structure may be formed by selectively forming a conformal dielectric layer on sidewalls but not bottom of the first TSV opening to leave exposed the Vdd power connection feature; partially filling the first TSV opening with one or more first conductive layers to form at least part of the conductive power TSV structure; and filling the first TSV opening with one or more second conductive layers to form the conductive power TSV structure, where the conformal dielectric layer prevents direct electrical connection between the conductive power TSV structure and the first decoupling conductive power TSV structure capacitor plate.

In yet another form, there has been provided an integrated circuit and associated method of fabrication. As disclosed, the integrated circuit includes a semiconductor substrate having plurality of integrated circuit (IC) devices formed on a frontside of the semiconductor substrate and a first integrated connection feature and a second integrated connection feature formed in or over the semiconductor substrate. In addition, the integrated circuit includes a capacitor formed on a backside of the semiconductor substrate comprising first and second capacitor plates separated by a capacitor dielectric layer. In selected embodiments, the capacitor may be a decoupling capacitor that covers the entirety of the semiconductor substrate, but in other embodiments, the first and second capacitor plates may also be patterned and etched to form other circuit capacitors. The integrated circuit also includes a first conductive TSV structure formed through the backside of the semiconductor substrate to directly, electrically connect the first integrated connection feature to the second capacitor plate, but not to the first capacitor plate. In addition, the integrated circuit includes a second TSV structure formed through the backside of the semiconductor substrate to directly, electrically connect the second integrated connection feature to the first capacitor plate, but not to the second capacitor plate.

Although the described exemplary embodiments disclosed herein are directed to various semiconductor and integrated circuit device structures and methods for making the same, the particular embodiments disclosed above are illustrative only and should not be taken as limitations upon the present invention, as the invention may be modified and practiced in different but equivalent manners apparent to those skilled in the art having the benefit of the teachings herein. Accordingly, the foregoing description is not intended to limit the invention to the particular form set forth, but on the contrary, is intended to cover such alternatives, modifications and equivalents as may be included within the scope of the invention as defined by the appended claims so that those skilled in the art should understand that they can make various changes, substitutions and alterations without departing from the scope of the claims.

Benefits, other advantages, and solutions to problems have been described above with regard to specific embodiments. However, the benefits, advantages, solutions to problems, and any element(s) that may cause any benefit, advantage, or solution to occur or become more pronounced are not to be construed as a critical, required, or essential feature or element of any or all the claims. As used herein, the terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus.

## Claims

1. A method, comprising:
providing a semiconductor wafer containing a plurality of integrated circuit, IC, devices (12) formed on a frontside of a semiconductor substrate layer (10) in which integrated device connection features (11, 101, 102) are formed;
forming a decoupling capacitor on a backside of the semiconductor substrate layer (10) comprising a first capacitor plate (14), a capacitor dielectric layer (15), and a second capacitor plate (16);
selectively etching a plurality of through-semiconductor via, TSV, openings (17, 21, 103, 104) through the decoupling capacitor and the backside of the semiconductor substrate layer (10) to contact the integrated device connection features (11, 101, 102);
forming, in a first TSV opening (21, 103) of each IC device, a first voltage supply TSV conductor (25, 107, 120) which provides a direct electrical connection between the first capacitor plate (14) and a first integrated device connection feature (11, 101) formed in the semiconductor substrate layer (10);
forming, in a second TSV opening (17, 104) of each IC device, a second voltage supply TSV conductor (25, 30, 107, 121) which provides a direct electrical connection between the second capacitor plate (16) and a second integrated device connection feature (11, 102) formed in the semiconductor substrate layer; and
singulating the semiconductor wafer into multiple integrated circuit die;
where the first voltage supply TSV conductor (25, 107, 120) is not directly, electrically connected to the second capacitor plate (16), and where the second voltage supply TSV conductor (25, 30, 107, 121) is not directly, electrically connected to the first capacitor plate (14).

2. The method of claim 1, where the integrated device connection features formed in the semiconductor substrate layer (10) are at least one selected from a group consisting of a highly doped semiconductor connection region or buried power rail connection region (11) formed in the semiconductor substrate layer (10).

3. The method of claim 1 or 2, where the decoupling capacitor comprises a first decoupling capacitor plate (14) formed to cover the backside of the semiconductor substrate layer (10), a high-k capacitor dielectric layer (15) formed to cover the first decoupling capacitor plate (14), and a second decoupling capacitor plate (16) formed to cover the high-k capacitor dielectric layer (15).

4. The method of any preceding claim, where selectively etching the plurality of TSV openings comprises sequentially etching the first and second TSV openings (17, 21) through the decoupling capacitor and the backside of the semiconductor substrate layer (10) to contact the integrated device connection features (11).

5. The method of claim 4, where forming the first voltage supply TSV conductor comprises:
partially filling the first TSV opening (21) with one or more first conductive layers (25) to form at least part of the first voltage supply TSV conductor in direct electrical connection between the first capacitor plate (14) and the first integrated device connection feature (11);
selectively forming an insulating dielectric layer (26) in unfilled portions of the first TSV opening (21); and
filling unfilled portions of the first TSV opening (21) with one or more second conductive layers,
where the insulating dielectric layer (26) prevents direct electrical connection between the first voltage supply TSV conductor and the second capacitor plate (16).

6. The method of claim 4 or 5, where forming the second voltage supply TSV conductor comprises:
selectively forming a conformal dielectric layer (18) on sidewalls but not bottom of the second TSV opening (17) to leave exposed the second integrated device connection feature (11);
partially filling the second TSV opening (17) with one or more first conductive layers (25) to form at least part of the second voltage supply TSV conductor; and
filling the second TSV opening (17) with one or more second conductive layers (30) to form the second voltage supply TSV conductor,
where the conformal dielectric layer (18) prevents direct electrical connection between the second voltage supply TSV conductor and the first capacitor plate (14).

7. The method of any preceding claim, where selectively etching the plurality of TSV openings comprises simultaneously etching the first and second TSV openings (103, 104) through the decoupling capacitor and the backside of the semiconductor substrate layer (10) to contact the integrated device connection features (101, 102).

8. The method of claim 7, where forming the first voltage supply TSV conductor comprises:
selectively forming a conformal dielectric layer on sidewalls but not bottom of the first TSV opening (103) to leave exposed the first integrated device connection feature (101);
partially filling the first TSV opening (103) with one or more first conductive layers (107) to form at least part of the first voltage supply TSV conductor;
selectively etching the conformal dielectric layer from a portion of the sidewalls of the first TSV opening (103) to expose the first capacitor plate (14); and
filling the first TSV opening (103) with one or more second conductive layers (119, 120) in direct electrical connection with the first capacitor plate (14) and the one or more first conductive layers (107),
where unetched portions of the conformal dielectric layer prevent direct electrical connection between the first voltage supply TSV conductor and the second capacitor plate (16).

9. The method of claim 7 or 8, where forming the second voltage supply TSV conductor comprises:
selectively forming a conformal dielectric layer on sidewalls but not bottom of the second TSV opening (104) to leave exposed the second integrated device connection feature (102);
partially filling the second TSV opening (104) with one or more first conductive layers (107) to form at least part of the second voltage supply TSV conductor; and
filling the second TSV opening (104) with one or more second conductive layers (119, 121) to form the second voltage supply TSV conductor,
where the conformal dielectric layer prevents direct electrical connection between the second voltage supply TSV conductor and the first capacitor plate (14).

10. An integrated circuit (27), comprising:
a semiconductor substrate (10) comprising plurality of integrated circuit, IC, devices (12) formed on a frontside of the semiconductor substrate (10) and a first integrated connection feature (102) and a second integrated connection feature (101) formed in or over the semiconductor substrate (10);
a decoupling capacitor formed on a backside of the semiconductor substrate (10) comprising first and second capacitor plates (14, 16) separated by a capacitor dielectric layer (15);
a first conductive TSV structure (121, 107) formed in a first TSV opening through the decoupling capacitor and the backside of the semiconductor substrate (10) to directly, electrically connect the first integrated connection feature (102) to the second capacitor plate (16), but not to the first capacitor plate (14); and
a second conductive TSV structure (120, 107) formed in a second TSV opening through the decoupling capacitor and the backside of the semiconductor substrate (10) to directly, electrically connect the second integrated connection feature (101) to the first capacitor plate (14), but not to the second capacitor plate (16).

## Patentansprüche

1. Verfahren, das Folgendes umfasst:
Bereitstellen eines Halbleiterwafers, der mehrere Integrierter-Schaltkreis- bzw. IC(Integrated Circuit)-Vorrichtungen (12) enthält, die auf einer Vorderseite einer Halbleitersubstratschicht (10) gebildet sind, in der integrierte Vorrichtungsverbindungsmerkmale (11, 101, 102) gebildet sind;
Bilden eines Entkopplungskondensators auf einer Rückseite der Halbleitersubstratschicht (10), welcher eine erste Kondensatorplatte (14), eine Kondensatordielektrikumschicht (15) und eine zweite Kondensatorplatte (16) umfasst;
selektives Ätzen mehrerer Halbleiterdurchkontaktierung- bzw. TSV(Through-Semiconductor Via)-Öffnungen (17, 21, 103, 104) durch den Entkopplungskondensator und die Rückseite der Halbleitersubstratschicht (10), um die integrierten Vorrichtungsverbindungsmerkmale (11, 101, 102) zu kontaktieren;
Bilden, in einer ersten TSV-Öffnung (21, 103) jeder IC-Vorrichtung, eines ersten Spannungsversorgung-TSV-Leiters (25, 107, 120), der eine direkte elektrische Verbindung zwischen der ersten Kondensatorplatte (14) und einem ersten integrierten Vorrichtungsverbindungsmerkmal (11, 101) bereitstellt, das in der Halbleitersubstratschicht (10) gebildet wird;
Bilden, in einer zweiten TSV-Öffnung (17, 104) jeder IC-Vorrichtung, eines zweiten Spannungsversorgung-TSV-Leiters (25, 30, 107, 121), der eine direkte elektrische Verbindung zwischen der zweiten Kondensatorplatte (16) und einem zweiten integrierten Vorrichtungsverbindungsmerkmal (11, 102) bereitstellt, das in der Halbleitersubstratschicht gebildet wird; und Vereinzeln des Halbleiterwafers in mehrere Integrierter-Schaltkreis-Dies;
wobei der erste Spannungsversorgung-TSV-Leiter (25, 107, 120) nicht direkt elektrisch mit der zweiten Kondensatorplatte (16) verbunden ist und wobei der zweite Spannungsversorgung-TSV-Leiter (25, 30, 107, 121) nicht direkt elektrisch mit der ersten Kondensatorplatte (14) verbunden ist.

2. Verfahren nach Anspruch 1, wobei die in der Halbleitersubstratschicht (10) gebildeten integrierten Vorrichtungsverbindungsmerkmale wenigstens eines sind, das aus einer Gruppe ausgewählt ist, die aus einem stark dotierten Halbleiterverbindungsgebiet oder einem vergrabenen Leistungsschienenverbindungsgebiet (11) besteht, das in der Halbleitersubstratschicht (10) gebildet ist.

3. Verfahren nach Anspruch 1 oder 2, wobei der Entkopplungskondensator eine erste Entkopplungskondensatorplatte (14), die so gebildet ist, dass sie die Rückseite der Halbleitersubstratschicht (10) bedeckt, eine High-k-Kondensatordielektrikumschicht (15), die so gebildet ist, dass sie die erste Entkopplungskondensatorplatte (14) bedeckt, und eine zweite Entkopplungskondensatorplatte (16), die so gebildet ist, dass sie die High-k-Kondensatordielektrikumschicht (15) bedeckt, umfasst.

4. Verfahren nach einem der vorhergehenden Ansprüche, wobei das selektive Ätzen der mehreren TSV-Öffnungen sequentielle Ätzen der ersten und zweiten TSV-Öffnungen (17, 21) durch den Entkopplungskondensator und die Rückseite der Halbleitersubstratschicht (10) umfasst, um die integrierten Vorrichtungsverbindungsmerkmale (11) zu kontaktieren.

5. Verfahren nach Anspruch 4, wobei das Bilden des ersten Spannungsversorgung-TSV-Leiters Folgendes umfasst:
partielles Füllen der ersten TSV-Öffnung (21) mit einer oder mehreren ersten leitfähigen Schichten (25), um wenigstens einen Teil des ersten Spannungsversorgung-TSV-Leiters in direkter elektrischer Verbindung zwischen der ersten Kondensatorplatte (14) und dem ersten integrierten Vorrichtungsverbindungsmerkmal (11) zu bilden;
selektives Bilden einer isolierenden dielektrischen Schicht (26) in ungefüllten Abschnitten der ersten TSV-Öffnung (21); und
Füllen ungefüllter Abschnitte der ersten TSV-Öffnung (21) mit einer oder mehreren zweiten leitfähigen Schichten, wobei die isolierende dielektrische Schicht (26) eine direkte elektrische Verbindung zwischen dem ersten Spannungsversorgung-TSV-Leiter und der zweiten Kondensatorplatte (16) verhindert.

6. Verfahren nach Anspruch 4 oder 5, wobei das Bilden des zweiten Spannungsversorgung-TSV-Leiters Folgendes umfasst:
selektives Bilden einer konformen dielektrischen Schicht (18) auf Seitenwänden, aber nicht auf einer Unterseite der zweiten TSV-Öffnung (17), um das zweite integrierte Vorrichtungsverbindungsmerkmal (11) freiliegend zu belassen;
partielles Füllen der zweiten TSV-Öffnung (17) mit einer oder mehreren ersten leitfähigen Schichten (25), um wenigstens einen Teil des zweiten Spannungsversorgung-TSV-Leiters zu bilden; und
Füllen der zweiten TSV-Öffnung (17) mit einer oder mehreren zweiten leitfähigen Schichten (30), um den zweiten Spannungsversorgung-TSV-Leiter zu bilden,
wobei die konforme dielektrische Schicht (18) eine direkte elektrische Verbindung zwischen dem zweiten Spannungsversorgung-TSV-Leiter und der ersten Kondensatorplatte (14) verhindert.

7. Verfahren nach einem der vorhergehenden Ansprüche, wobei das selektive Ätzen der mehreren TSV-Öffnungen gleichzeitiges Ätzen der ersten und zweiten TSV-Öffnungen (103, 104) durch den Entkopplungskondensator und die Rückseite der Halbleitersubstratschicht (10) umfasst, um die integrierten Vorrichtungsverbindungsmerkmale (101, 102) zu kontaktieren.

8. Verfahren nach Anspruch 7, wobei das Bilden des ersten Spannungsversorgung-TSV-Leiters Folgendes umfasst:
selektives Bilden einer konformen dielektrischen Schicht auf Seitenwänden, aber nicht auf einer Unterseite der ersten TSV-Öffnung (103), um das erste integrierte Vorrichtungsverbindungsmerkmal (101) freiliegend zu belassen;
partielles Füllen der ersten TSV-Öffnung (103) mit einer oder mehreren ersten leitfähigen Schichten (107), um wenigstens einen Teil des ersten Spannungsversorgung-TSV-Leiters zu bilden;
selektives Ätzen der konformen dielektrischen Schicht von einem Abschnitt der Seitenwände der ersten TSV-Öffnung (103), um die erste Kondensatorplatte (14) freizulegen; und
Füllen der ersten TSV-Öffnung (103) mit einer oder mehreren zweiten leitfähigen Schichten (119, 120) in direkter elektrischer Verbindung mit der ersten Kondensatorplatte (14) und der einen oder den mehreren ersten leitfähigen Schichten (107),
wobei nichtgeätzte Abschnitte der konformen dielektrischen Schicht eine direkte elektrische Verbindung zwischen dem ersten Spannungsversorgung-TSV-Leiter und der zweiten Kondensatorplatte (16) verhindern.

9. Verfahren nach Anspruch 7 oder 8, wobei das Bilden des zweiten Spannungsversorgung-TSV-Leiters Folgendes umfasst:
selektives Bilden einer konformen dielektrischen Schicht auf Seitenwänden, aber nicht auf einer Unterseite der zweiten TSV-Öffnung (104), um das zweite integrierte Vorrichtungsverbindungsmerkmal (102) freiliegend zu belassen;
partielles Füllen der zweiten TSV-Öffnung (104) mit einer oder mehreren ersten leitfähigen Schichten (107), um wenigstens einen Teil des zweiten Spannungsversorgung-TSV-Leiters zu bilden; und
Füllen der zweiten TSV-Öffnung (104) mit einer oder mehreren zweiten leitfähigen Schichten (119, 121), um den zweiten Spannungsversorgung-TSV-Leiter zu bilden,
wobei die konforme dielektrische Schicht eine direkte elektrische Verbindung zwischen dem zweiten Spannungsversorgung-TSV-Leiter und der ersten Kondensatorplatte (14) verhindert.

10. Integrierter Schaltkreis (27), der Folgendes umfasst:
ein Halbleitersubstrat (10), das mehrere Integrierter-Schaltkreis- bzw. IC-Vorrichtungen (12), die auf einer Vorderseite des Halbleitersubstrats (10) gebildet sind, und ein erstes integriertes Verbindungsmerkmal (102) und ein zweites integriertes Verbindungsmerkmal (101), die in oder über dem Halbleitersubstrat (10) gebildet sind, umfasst;
einen Entkopplungskondensator, der auf einer Rückseite des Halbleitersubstrats (10) gebildet ist und der eine erste und eine zweite Kondensatorplatte (14, 16) umfasst,
die durch eine Kondensatordielektrikumschicht (15) getrennt sind;
eine erste leitfähige TSV-Struktur (121, 107), die in einer ersten TSV-Öffnung durch den Entkopplungskondensator und die Rückseite des Halbleitersubstrats (10) gebildet ist, um das erste integrierte Verbindungsmerkmal (102) direkt elektrisch mit der zweiten Kondensatorplatte (16), aber nicht mit der ersten Kondensatorplatte (14) zu verbinden; und
eine zweite leitfähige TSV-Struktur (120, 107), die in einer zweiten TSV-Öffnung durch den Entkopplungskondensator und die Rückseite des Halbleitersubstrats (10) gebildet ist, um das zweite integrierte Verbindungsmerkmal (101) direkt elektrisch mit der ersten Kondensatorplatte (14), aber nicht mit der zweiten Kondensatorplatte (16) zu verbinden.

## Revendications

1. Procédé comprenant :
la fourniture d'une plaquette de semi-conducteur contenant une pluralité de dispositifs de circuit intégré, IC (12) formés sur une face avant d'une couche de substrat semi-conducteur (10) dans laquelle des caractéristiques de connexion de dispositif intégré (11, 101, 102) sont formées ;
la formation d'un condensateur de découplage sur une face arrière de la couche de substrat semi-conducteur (10) comprenant une première plaque de condensateur (14), une couche diélectrique de condensateur (15), et une deuxième plaque de condensateur (16) ;
la gravure sélective d'une pluralité d'ouvertures de trou d'interconnexion semi-conducteur traversant, TSV (17, 21, 103, 104) à travers le condensateur de découplage et la face arrière de la couche de substrat semi-conducteur (10) pour venir en contact avec les caractéristiques de connexion de dispositif intégré (11, 101, 102) ;
la formation, dans une première ouverture TSV (21, 103) de chaque dispositif IC, d'un premier conducteur TSV d'alimentation en tension (25, 107, 120) qui fournit une connexion électrique directe entre la première plaque de condensateur (14) et une première caractéristique de connexion de dispositif intégré (11, 101) formée dans la couche de substrat semi-conducteur (10) ;
la formation, dans une deuxième ouverture TSV (17, 104) de chaque dispositif IC, d'un deuxième conducteur TSV d'alimentation en tension (25, 30, 107, 121) qui fournit une connexion électrique directe entre la deuxième plaque de condensateur (16) et une deuxième caractéristique de connexion de dispositif intégré (11, 102) formée dans la couche de substrat semi-conducteur ; et
la singularisation de la plaquette de semi-conducteur en de multiples puces de circuit intégré ;
le premier conducteur TSV d'alimentation en tension (25, 107, 120) n'étant pas directement connecté électriquement à la deuxième plaque de condensateur (16), et le deuxième conducteur TSV d'alimentation en tension (25, 30, 107, 121) n'étant pas directement connecté électriquement à la première plaque de condensateur (14).

2. Procédé selon la revendication 1, les caractéristiques de connexion de dispositif intégré formées dans la couche de substrat semi-conducteur (10) étant au moins une caractéristique sélectionnée dans un groupe constitué d'une région de connexion de semi-conducteur fortement dopée ou d'une région de connexion de rail d'alimentation enterré (11) formée dans la couche de substrat semi-conducteur (10).

3. Procédé selon la revendication 1 ou la revendication 2, le condensateur de découplage comprenant une première plaque de condensateur de découplage (14) formée pour recouvrir la face arrière de la couche de substrat semi-conducteur (10), une couche diélectrique de condensateur à k élevé (15) formée pour recouvrir la première plaque de condensateur de découplage (14), et une deuxième plaque de condensateur de découplage (16) formée pour recouvrir la couche diélectrique de condensateur à k élevé (15).

4. Procédé selon l'une quelconque des revendications précédentes, la gravure sélective de la pluralité d'ouvertures TSV comprenant la gravure séquentielle des première et deuxième ouvertures TSV (17, 21) à travers le condensateur de découplage et la face arrière de la couche de substrat semi-conducteur (10) pour venir en contact avec les caractéristiques de connexion de dispositif intégré (11).

5. Procédé selon la revendication 4, la formation du premier conducteur TSV d'alimentation en tension comprenant :
le remplissage partiel de la première ouverture TSV (21) avec une ou plusieurs premières couches conductrices (25) pour former au moins une partie du premier conducteur TSV d'alimentation en tension en connexion électrique directe entre la première plaque de condensateur (14) et la première caractéristique de connexion de dispositif intégré (11) ;
la formation sélective d'une couche diélectrique isolante (26) dans des parties non remplies de la première ouverture TSV (21) ; et
le remplissage de parties non remplies de la première ouverture TSV (21) avec une ou plusieurs deuxièmes couches conductrices,
la couche diélectrique isolante (26) empêchant une connexion électrique directe entre le premier conducteur TSV d'alimentation en tension et la deuxième plaque de condensateur (16).

6. Procédé selon la revendication 4 ou la revendication 5, la formation du deuxième conducteur TSV d'alimentation en tension comprenant :
la formation sélective d'une couche diélectrique conforme (18) sur des parois latérales mais pas sur le fond de la deuxième ouverture TSV (17) pour laisser exposée la deuxième caractéristique de connexion de dispositif intégré (11) ;
le remplissage partiel de la deuxième ouverture TSV (17) avec une ou plusieurs premières couches conductrices (25) pour former au moins une partie du deuxième conducteur TSV d'alimentation en tension ; et
le remplissage de la deuxième ouverture TSV (17) avec une ou plusieurs deuxièmes couches conductrices (30) pour former le deuxième conducteur TSV d'alimentation en tension,
la couche diélectrique conforme (18) empêchant une connexion électrique directe entre le deuxième conducteur TSV d'alimentation en tension et la première plaque de condensateur (14).

7. Procédé selon l'une quelconque des revendications précédentes, la gravure sélective de la pluralité d'ouvertures TSV comprenant la gravure simultanée des première et deuxième ouvertures TSV (103, 104) à travers le condensateur de découplage et la face arrière de la couche de substrat semi-conducteur (10) pour venir en contact avec les caractéristiques de connexion de dispositif intégré (101, 102).

8. Procédé selon la revendication 7, la formation du premier conducteur TSV d'alimentation en tension comprenant :
la formation sélective d'une couche diélectrique conforme sur des parois latérales mais pas sur le fond de la première ouverture TSV (103) pour laisser exposée la première caractéristique de connexion de dispositif intégré (101) ;
le remplissage partiel de la première ouverture TSV (103) avec une ou plusieurs premières couches conductrices (107) pour former au moins une partie du premier conducteur TSV d'alimentation en tension ;
la gravure sélective de la couche diélectrique conforme à partir d'une partie des parois latérales de la première ouverture TSV (103) pour exposer la première plaque de condensateur (14) ; et
le remplissage de la première ouverture TSV (103) avec une ou plusieurs deuxièmes couches conductrices (119, 120) en connexion électrique directe avec la première plaque de condensateur (14) et la ou les premières couches conductrices (107),
des parties non gravées de la couche diélectrique conforme empêchant une connexion électrique directe entre le premier conducteur TSV d'alimentation en tension et la deuxième plaque de condensateur (16).

9. Procédé selon la revendication 7 ou la revendication 8, la formation du deuxième conducteur TSV d'alimentation en tension comprenant :
la formation sélective d'une couche diélectrique conforme sur des parois latérales mais pas sur le fond de la deuxième ouverture TSV (104) pour laisser exposée la deuxième caractéristique de connexion de dispositif intégré (102) ;
le remplissage partiel de la deuxième ouverture TSV (104) avec une ou plusieurs premières couches conductrices (107) pour former au moins une partie du deuxième conducteur TSV d'alimentation en tension ; et
le remplissage de la deuxième ouverture TSV (104) avec une ou plusieurs deuxièmes couches conductrices (119, 121) pour former le deuxième conducteur TSV d'alimentation en tension,
la couche diélectrique conforme empêchant une connexion électrique directe entre le deuxième conducteur TSV d'alimentation en tension et la première plaque de condensateur (14).

10. Circuit intégré (27), comprenant :
un substrat semi-conducteur (10) comprenant une pluralité de dispositifs de circuit intégré, IC (12) formés sur une face avant du substrat semi-conducteur (10) et une première caractéristique de connexion intégrée (102) et une deuxième caractéristique de connexion intégrée (101) formées dans ou sur le substrat semi-conducteur (10) ;
un condensateur de découplage formé sur une face arrière du substrat semi-conducteur (10) comprenant des première et deuxième plaques de condensateur (14, 16) séparées par une couche diélectrique de condensateur (15) ;
une première structure TSV conductrice (121, 107) formée dans une première ouverture TSV à travers le condensateur de découplage et la face arrière du substrat semi-conducteur (10) pour connecter directement électriquement la première caractéristique de connexion intégrée (102) à la deuxième plaque de condensateur (16), mais pas à la première plaque de condensateur (14) ; et
une deuxième structure TSV conductrice (120, 107) formée dans une deuxième ouverture TSV à travers le condensateur de découplage et la face arrière du substrat semi-conducteur (10) pour connecter directement électriquement la deuxième caractéristique de connexion intégrée (101) à la première plaque de condensateur (14), mais pas à la deuxième plaque de condensateur (16).
